Europäisches Patentamt

European Patent Office

Office européen des brevets

(11) Publication number: **0 421 783 A2**

# EUROPEAN PATENT APPLICATION

(21) Application number: 90310875.1

(51) Int. Cl.⁵: **G01R 33/12**

(22) Date of filing: **04.10.90**

(30) Priority: **05.10.89 GB 8922490**

(43) Date of publication of application:
**10.04.91 Bulletin 91/15**

(84) Designated Contracting States:
**CH DE ES FR GB IT LI NL SE**

(71) Applicant: **Adwel Industries Limited**
**Stonefield Way**
**Ruislip Middlesex HA4 0YW(GB)**

(72) Inventor: **Pendlebury, Ronald John**
**12 Pear Tree Road**
**Ashford, Middlesex(GB)**

(74) Representative: **Newby, Martin John et al**
**J.Y. & G.W. Johnson Furnival House 14-18**
**High Holborn**
**London WC1V 6DE(GB)**

(54) **Testing of laminated magnetic cores.**

(57) A wheeled device for testing a laminated core has an axle carrying spaced apart wheels designed to ride over a surface of the core to be tested. The wheels and axle are made of ferromagnetic material and provide a flux path for magnetic flux in the core when the wheels contact the core. Means are provided for detecting the magnetic flux in said flux path to enable detection of faults in the core.

FIG. 1

# TESTING OF LAMINATED MAGNETIC CORES

This invention relates to a wheeled device for testing laminated magnetic cores.

In GB-A-2044936 there is disclosed a method of and apparatus for testing laminated magnetic cores, e.g. for the occurrence of "hot spots" in the core which can occur when the insulation between adjacent laminations in the core breaks down or is defective to enable current to flow between the adjacent laminations. The method disclosed involves the steps of inducing in the laminated core an alternating magnetic flux parallel to the laminations by driving an alternating electric current in an excitation winding, detecting the magnetic flux in a predetermined component direction at a selected location on a surface of the core normal to the laminations, monitoring the mean leakage flux outside the material of the core and indicating the magnitude of the component of the detected flux which is in phase quadrature with the mean leakage flux. The "mean leakage flux" is defined as being the leakage flux, in the air (usually) outside the material of the core, averaged over a large surface area of the core so as to be relatively insensitive to the effects of any local hot spots in the core. The present invention is concerned with a wheeled device which is capable of detecting the magnetic flux in the predetermined component direction so as to enable the indication of the magnitude of the component of the detected flux which is in phase quadrature with the mean leakage flux.

According to the present invention a wheeled device for testing a laminated magnetic core comprises an axle carrying spaced apart wheels designed to ride over a surface of the laminated magnetic core to be tested, the wheels and axle being made of ferromagnetic material and providing a magnetic flux path for magnetic flux in the core when the wheels contact the core, and means for detecting the magnetic flux in the said flux path during travel of the wheeled device over the laminated magnetic core to enable the location of faults in the core.

Preferably the detecting means is arranged to detect magnetic flux in the said axle.

The detecting means is suitably designed to detect flux in a certain direction and at a selected location on the surface of the core and to indicate the magnitude of the component of the detected flux in phase quadrature with the mean leakage flux. To this end, the output of the detecting means is sent to a signal processor which separates the quadrature component from the mean leakage flux.

The device may comprise a further axle carrying at least one further wheel, the or each further wheel being electrically insulated from the wheels on the first mentioned axle.

Preferably the device includes magnet means for magnetically retaining the device with its wheels in contact with a magnetic core to be tested. Suitably the or each axle incorporates a permanent magnet so that the two wheels attached to the axle are oppositely poled. Alternatively, each wheel may comprise a permanent magnet clamped between two spaced apart discs, the two discs of each wheel having opposite poles.

In the case where a wheel is not formed as a permanent magnet clamped between a pair of discs, the wheel may suitably consist of a conventional wheel bearing made of ferromagnetic components. In particular the wheel bearing typically comprises two annular components or races, the rolling elements, e.g. balls or rollers, and a cage for retaining the rolling elements in position between the races. The or each wheel may be adjustably axially positionable on its axle to adjust the spacing apart of the wheels.

Embodiments of the invention will now be described, by way of example only, with reference to the accompanying drawings, in which:

Figures 1 to 3 each show, respectively, an end view of part of a laminated magnetic core of an electrical machine on which is positioned a different embodiment of wheeled device, according to the invention, for testing for faults in the magnetic core,

Figure 1A shows a partial perspective view of part of a wheeled device according to the invention illustrating an adjustable mounting of a ferromagnetic wheel on an axle, and

Figure 4 is a schematic plan of a wheeled device according to the invention.

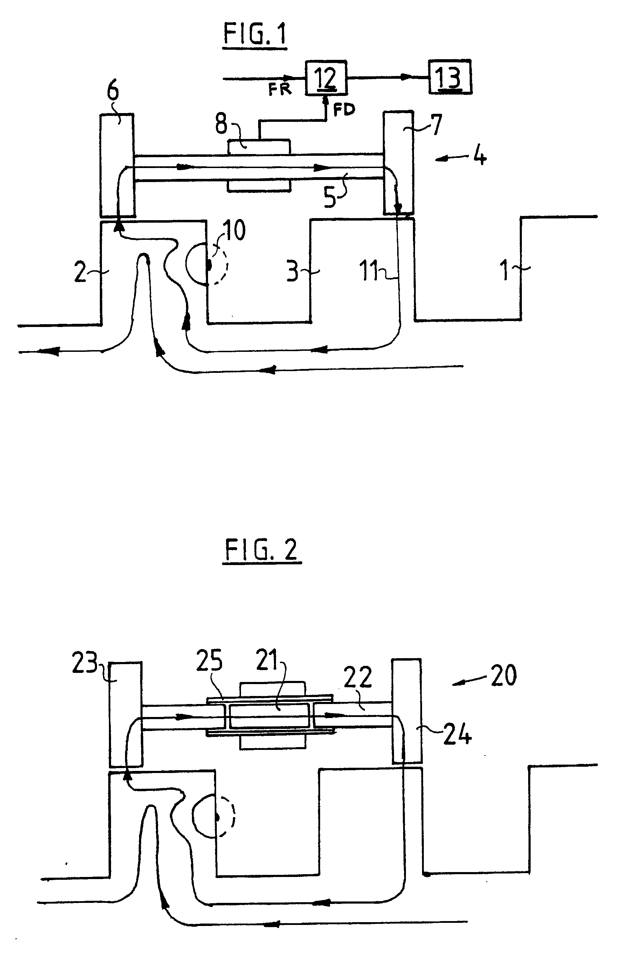

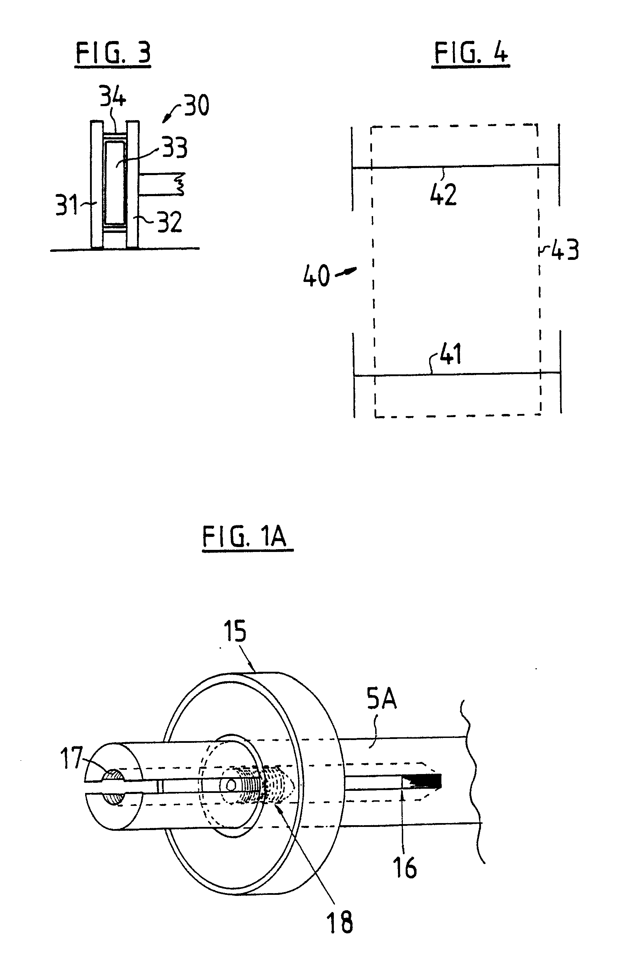

Figure 1 of the present specification shows part of the inside surface of a laminated magnetic core 1 of an electric generator of the type shown in Figure 1 of GB-A-2044936. As can be seen from Figure 1 of GB-A-2044936, the inner surface of the electric generator is formed as a series of axially extending teeth and two such axial teeth 2 and 3 are identified in Figure 1 of the present specification. A wheeled device 4 according to the invention is positioned on the core 1 and has a wheeled axle 5 with metallic wheels 6 and 7 contacting the teeth 2 and 3, respectively, and a flux detector 8 mounted on the axle 5. The wheeled axle 5 may form the front or rear axle of a two axle vehicle. In this case the front and rear axles are made of ferromagnetic material, e.g. steel, and are mounted in any convenient manner in a chassis or frame (not shown) made of non-ferromagnetic material.

In use of the device 1, a circumferentially extending alternating magnetic flux is generated in the core 1 by exciting an excitation winding (not shown) wound around the core. The flux 11 resulting from the electrical current induced in the core at a "hot spot" 10 will be out of phase with the mean leakage flux immediately outside the stator core produced directly by the excitation winding and which is in phase with the driving current in the excitation winding. The device 1 is able to detect the total flux produced by a "hot spot" and via a signal processor unit 12 an indication of the magnitude of the component of the detected flux which is in phase quadrature with the mean leakage flux is obtained.

As shown in Figure 1, the path of the flux 11 resulting from the electrical current induced in the core 1 at the "hot spot" 10 passes from the core tooth 2, through the deice 1 via the wheel 6, axle 5 and wheel 7 and to the core tooth 3. The detector 8 is able to detect the flux passing through the axle 5. A flux detector signal FD from the output of the detector 8 is sent to the signal processor unit 12 which receives a reference signal FR derived from the mean leakage flux. The signal processor unit 12 separates the component due to the "hot spot" current and provides an output to a level indicator 13. The output component of the flux detector signal is 90° out of phase with the main leakage flux signal.

In order to provide a good magnetic circuit for the magnetic flux created by the fault current at the "hot spot" 10, the wheels 6 and 7 and axle 5 are made of ferromagnetic material. A particularly advantageous design is for each wheel to be in the form of metallic wheel bearing, e.g. of the type having inner and outer races, rolling elements (balls or rollers) and a cage for retaining the rolling elements in position between the races. The or each wheel 6,7 may be adjustably positioned on the axle 5 in order to enable adjustment of the separation of the wheels 6 and 7. Figure 1A illustrates one method of adjustably mounting a wheel in the form of a ferromagnetic single row radial ball bearing 15 on a shaft 5A. The end of the shaft 5A is provided with a diametric slot 16 and a threaded bore 17. The bearing is adjustably axially positioned on the shaft 5A in the region of the slot 16 and an allen screw 18 is screwed into the bore 17. As the allen screw 18 is tightened, the slotted end of the shaft 5A spreads apart and locks the bearing 15 to the shaft 5A.

In use, if the wheeled device 1 only has a single axle 5 it can be manually wheeled over the core to be tested. Alternatively, if the device 1 has a second axle, it can be provided with a motor and operated by remote control.

In Figure 2 there is shown a wheeled device 20 according to the invention which is similar to the device 1 but which is provided with a permanent magnet 21 in its axle 22. The provision of the magnet 21 in the axle 22 effectively makes the two wheels 23, 24 mounted at each end of the axle have opposite magnetic polarity. The wheel pair thus acts as a magnet for retaining the device 20 magnetically against the laminated magnetic core. As shown, a sleeve 25 holds the detector 26 and provides support for parts of the axle 22.

As an alternative to providing a permanent magnet in the axle, a wheeled device according to the invention may have each of its wheels formed as a magnet. For example in Figure 3 there is shown one wheel 30 of such a device comprising a permanent magnet 33 clamped between a pair of spaced apart ferromagnetic, e.g. steel, rings or plates 31 and 32. A non-magnetic protective cover 34 surrounds the magnet 33. The two plates 31 and 32 thus become oppositely poled and the wheel 30 acts as a magnet for holding a wheeled device according to the invention against a ferromagnetic surface.

Figure 4 illustrates schematically a wheeled device 40 according to the invention having front and rear wheeled axles 41 and 42 mounted on a non-magnetic chassis 43. The wheels on axle 41 are thus magnetically "insulated" from the wheels on axle 42 if the two sets of wheels travel on different core laminations and thus prevent circulating currents due to the voltage difference between the laminations created by the alternating magnetic excitation of the core.

## Claims

1. A wheeled device (4) for testing a laminated magnetic core (1) is characterised in that the wheeled device (4) comprises an axle (5) carrying spaced apart wheels (6, 7) designed to ride over a surface of the laminated magnetic core (1) to be tested, the wheels and axle being made of ferromagnetic material and providing a magnetic flux path (11) for magnetic flux in the core (1) when the wheels (6, 7) contact the core (1), and means (8) for detecting the magnetic flux in the said flux path (11) during travel of the wheeled device (4) over the laminated magnetic core (1) to enable the location of faults in the core.

2. A device according to claim 1, characterised in that the detecting means (8) is designed to detect flux in a certain direction and at a selected location on the surface of the core for deriving information on the magnitude of the component of the detected flux in phase quadrature with the mean leakage flux.

3. A device according to claim 2, characterised in that the detecting means (8) has output means for sending an output signal to a signal processor for separating the quadrature component from the mean leakage flux.

4. A device according to any of the preceding claims, characterised by a further axle (41 or 42) carrying at least one further wheel, the or each further wheel being electrically insulated from the wheels on the first mentioned axle.

5. A device according to any of the preceding claims, characterised by magnetic means (21, 23, 24) for magnetically retaining the device with its wheels in contact with a magnetic core to be tested.

6. A device according to claim 5, characterised in that the or each axle (22) incorporates a permanent magnet (21) so that the two wheels (23, 24) attached to the axle are oppositely poled.

7. A device according to claim 5, characterised in that each wheel (30) comprises a permanent magnet (33) clamped between two spaced apart discs (31, 32), the two discs of each wheel having opposite poles.

8. A device according to any of claims 1 to 6, characterised in that the or each wheel consists of a wheel bearing made of ferromagnetic components.

9. A device according to claim 8, characterised in that the wheel bearing comprises two annular components or races, rolling elements, and a cage for retaining the rolling elements in position between the races.

10. A device according to claim 9, characterised in that the or each wheel is adjustably axially positionable on its axle to adjust the spacing apart of the wheels.

## FIG. 1

## FIG. 2

## FIG. 3

34 33 30 31 32

## FIG. 4

40 42 43 41

## FIG. 1A

15 5A 17 16 18